# EUROPÄISCHE PATENTSCHRIFT

(11) **EP 3 974 108 B1**
(45) Veröffentlichungstag und Bekanntmachung des Hinweises auf die Patenterteilung: **19.10.2022**
(21) Anmeldenummer: 21192580.5
(22) Anmeldetag: 23.08.2021
(51) Int. Cl.: B24B 37/12, B24B 49/08, B24B 49/14

(54) **DOPPEL- ODER EINSEITEN-BEARBEITUNGSMASCHINE**
DOUBLE OR SINGLE-SIDE MACHINING MACHINE
MACHINE À USINER DOUBLE OU SIMPLE FACE

(30) Priorität: 28.09.2020 DE 102020125246
(43) Veröffentlichungstag der Anmeldung: 30.03.2022
(73) Patentinhaber: Lapmaster Wolters GmbH, 24768 Rendsburg (DE)
(72) Erfinder: Boller, Hans-Peter, 24787 Fockbeck (DE); Neuber, Ingo, 24214 Bornstein (DE)
(74) Vertreter: Hauck Patentanwaltspartnerschaft mbB

(56) Entgegenhaltungen:
- DE-A1-102016 102 223
- DE-B4-102006 037 490

## Beschreibung

Die Erfindung betrifft eine Doppel- oder Einseiten-Bearbeitungsmaschine mit einer vorzugsweise ringförmigen ersten Arbeitsscheibe, die an einer ersten Trägerscheibe befestigt ist, und mit einem Gegenlagerelement, wobei die erste Arbeitsscheibe und das Gegenlagerelement über mindestens eine Antriebswelle relativ zueinander drehend antreibbar sind, wobei zwischen der ersten Arbeitsscheibe und dem Gegenlagerelement ein Arbeitsspalt zum beid- oder einseitigen Bearbeiten flacher Werkstücke gebildet ist, wobei zwischen der ersten Trägerscheibe und der ersten Arbeitsscheibe ein Druckvolumen angeordnet ist, das mit einer Druckfluidversorgung verbunden ist, die derart ansteuerbar ist, dass in dem Druckvolumen ein Druck aufgebaut wird, der eine vorgegebene Verformung der ersten Arbeitsscheibe erzeugt, und wobei Temperierkanäle zum Temperieren der ersten Arbeitsscheibe vorgesehen sind, die mit einer Temperierfluidversorgung verbunden sind.

Beispielsweise in Doppelseiten-Bearbeitungsmaschinen werden flache Werkstücke wie Wafer, gleichzeitig beidseitig bearbeitet. Dazu weisen Doppelseiten-Bearbeitungsmaschinen eine obere Arbeitsscheibe und eine untere Arbeitsscheibe auf, zwischen denen ein Arbeitsspalt gebildet ist, in dem die zu bearbeitenden Werkstücke während der Bearbeitung geführt werden. Die obere Arbeitsscheibe ist an einer oberen Trägerscheibe befestigt und die untere Arbeitsscheibe ist an einer unteren Trägerscheibe befestigt. Für die Bearbeitung wird eine Relativdrehung zwischen den Arbeitsscheiben herbeigeführt, indem mindestens eine der Arbeitsscheiben gemeinsam mit ihrer Trägerscheibe drehend angetrieben wird. Bekannt sind Doppelseiten-Bearbeitungsmaschinen, bei denen im Arbeitsspalt so genannte Läuferscheiben geführt sind. Die Läuferscheiben nehmen in der Regel in kreisrunden Öffnungen zu bearbeitende Werkstücke schwimmend auf. Durch eine geeignete Kinematik wird sichergestellt, dass sich die Läuferscheiben im Zuge der Relativdrehung der Arbeitsscheiben ebenfalls in dem Arbeitsspalt drehen. Dadurch bewegen sich die Werkstücke in dem Arbeitsspalt entlang zykloider Bahnen. Hierdurch wird eine besonders gleichmäßige Oberflächenbearbeitung erreicht.

Bei Bearbeitungsmaschinen der hier in Rede stehenden Art tritt durch die während der Bearbeitung entstehende Prozesswärme eine Veränderung des Arbeitsspaltes zwischen den Arbeitsscheiben auf. Insbesondere kommt es zu einer wärmebedingten Verformung der Arbeitsscheiben und damit einer Abweichung der Spaltgeometrie von der vorgegebenen Form. Hierdurch wird das Bearbeitungsergebnis negativ beeinträchtigt. Dies gilt insbesondere für die sehr hohen Bearbeitungsanforderungen sogenannter Prime-Wafer.

Aus DE 100 07 390 B4 ist eine Zweischeibenpoliermaschine bekannt, insbesondere zur Bearbeitung von Halbleiterwafern. Dabei sind in einer eine Polierscheibe tragenden Trägerscheibe oder in der Trägerscheibe und in der Polierscheibe Kühlkanäle ausgebildet, durch die eine Kühlung erfolgt, um unerwünschte Einflüsse auf die Geometrie des Arbeitsspalts zu verhindern. Außerdem ist zwischen einem Grundträger und der Trägerscheibe eine relative radiale Bewegung zugelassen, wodurch eine Verformung bei unterschiedlichen Temperaturen von Grundträger und Trägerscheibe verringert wird.

Aus DE 10 2004 040 429 B4 ist es bekannt, negativen Effekten durch auftretende Prozesswärme mittels einer Temperierung der Arbeitsscheiben entgegenzuwirken. Dabei sind Kanäle in den Trägerscheiben ausgebildet, durch die ein entsprechendes Temperierfluid, beispielsweise Kühlwasser, geleitet wird. Mit diesen Temperiereinrichtungen lassen sich in der Praxis allerdings höchste Präzisionsanforderungen bei der Bearbeitung nicht immer sicherstellen.

Aus DE 10 2006 037 490 B4 ist darüber hinaus eine Einrichtung zur mechanischen Verformung der oberen Trägerscheibe und mit ihr der an ihr befestigten oberen Arbeitsscheibe bekannt. Mit dieser Einrichtung kann eine zunächst ebene Arbeitsfläche der oberen Arbeitsscheibe in eine leicht konkave Fläche verändert werden. Umgekehrt kann eine zunächst leicht konvexe Arbeitsfläche der oberen Arbeitsscheibe in eine plane bzw. konkave Arbeitsfläche verändert werden. Auch mit dieser globalen Verformung der oberen Arbeitsscheibe lassen sich im Betrieb nicht sämtliche durch auftretende Prozesswärme entstehenden Abweichungen von der idealen Spaltgeometrie ausgleichen.

Aus DE 10 2016 102 223 A1, welche die Basis für den Oberbegriff des Anspruchs 1 bildet, ist eine Doppel- oder Einseiten-Bearbeitungsmaschine bekannt mit Mitteln zur lokalen Verformung zumindest einer der Arbeitsscheiben, insbesondere durch Einleiten eines Druckmittels, wie zum Beispiel Wasser, in einen auf die Arbeitsscheibe wirkenden Druckraum. Auf diese Weise kann zum Beispiel eine lokale konkave oder konvexe Verformung der Arbeitsscheibe erzeugt werden. Darüber hinaus sind in einer Trägerscheibe der Arbeitsscheibe Kühlkanäle ausgebildet zur Kühlung. Zusätzlich können Mittel zum Erzeugen einer globalen Verformung vorgesehen sein, wie diese in DE 10 2006 037 490 B4 beschrieben sind.

Ein Problem bei bekannten Systemen besteht darin, dass sich die den Arbeitsspalt direkt begrenzende Arbeitsscheibe im Betrieb stärker erwärmen kann als die diese tragende Trägerscheibe. Dadurch kann es zu Verspannungen zwischen der Arbeitsscheibe und der Trägerscheibe kommen. Je nach Temperaturdifferenz kann es auch zu einer gegenseitigen Verschiebung von Trägerscheibe und Arbeitsscheibe kommen. Bei einer anschließenden Abkühlung nach dem Betrieb kehren die Scheiben aufgrund einer der Bewegung entgegenwirkenden Reibkraft, beispielsweise durch eine Verschraubung, nicht vollständig in ihre vorherige Position zurück. Es kann damit auch nach vollständigem Abkühlen zwischen den Scheiben eine Kraftdifferenz verbleiben in Höhe der doppelten Reibkraft. Hierdurch wiederum kann es zu unterschiedlichen lokalen Geometrien kommen. Außerdem kann durch die veränderte Verspannung zwischen Trägerscheibe und Arbeitsscheibe auch die globale Geometrie der Arbeitsscheibe verändert werden. Auch zwischen einer den Arbeitsspalt begrenzenden Seite der Arbeitsscheibe und einer gegenüberliegenden Seite der Arbeitsscheibe können im Betrieb erhebliche Temperaturdifferenzen auftreten. Diese können zu unterschiedlichen Wärmeausdehnungen der beiden Seiten führen, wodurch es zu einer Wölbung der Arbeitsscheibe und damit ebenfalls einer Veränderung der lokalen Geometrie kommen kann.

Derartige Geometrieänderungen wirken sich negativ auf das Bearbeitungsergebnis aus und müssen beispielsweise mit den zum Stand der Technik erläuterten Mitteln aufwendig kompensiert werden. Im Stand der Technik nach DE 10 2016 102 223 A1 sind die Flexibilität beim Einstellen der gewünschten lokalen Geometrie sowie der für das Einstellen der lokalen Geometrie nutzbare Druck darüber hinaus begrenzt.

Ausgehend von dem erläuterten Stand der Technik liegt der Erfindung daher die Aufgabe zugrunde, eine Doppel- oder Einseiten-Bearbeitungsmaschine der eingangs genannten Arzt bereitzustellen, die es in einfacher, zuverlässiger und flexibler Weise erlaubt, die gewünschte Geometrie des Arbeitsspalts jederzeit sicherzustellen.

Die Erfindung löst die Aufgabe durch den Gegenstand von Anspruch 1. Vorteilhafte Ausgestaltungen finden sich in den abhängigen Ansprüchen, der Beschreibung und den Figuren.

Für eine Doppel- oder Einseiten-Bearbeitungsmaschine der eingangs genannten Art löst die Erfindung die Aufgabe dadurch, dass die Temperierkanäle innerhalb der ersten Arbeitsscheibe angeordnet sind, so dass die Temperierkanäle näher an dem Arbeitsspalt angeordnet sind als das Druckvolumen, und dass die Temperierkanäle nicht in Verbindung mit dem Druckvolumen stehen.

Bei der Bearbeitungsmaschine kann es sich beispielsweise um eine Poliermaschine oder eine Läppmaschine oder eine Schleifmaschine handeln. Zwischen der ersten Arbeitsscheibe und einem Gegenlagerelement, beispielsweise bei Einseiten-Bearbeitungsmaschinen einem einfachen Gewicht oder Druckzylinder bzw. bei Doppelseiten-Bearbeitungsmaschinen einer zweiten Arbeitsscheibe, ist ein Arbeitsspalt gebildet, in dem zu bearbeitende Werkstücke, zum Beispiel Wafer, beidseitig oder einseitig bearbeitet werden. Es kann sich also um eine DoppelseitenBearbeitungsmaschine oder eine Einseiten-Bearbeitungsmaschine handeln. Bei einer Doppelseiten-Bearbeitungsmaschine kann in dem Arbeitsspalt eine vorzugsweise gleichzeitige Bearbeitung von Unterseite und Oberseite der Werkstücke erfolgen. Entsprechend können beide Arbeitsscheiben eine die Werkstückoberfläche bearbeitende Arbeitsfläche aufweisen. Bei einer Einseiten-Bearbeitungsmaschine erfolgt dagegen eine Bearbeitung nur einer Werkstückseite, beispielsweise der Unterseite durch die untere Arbeitsscheibe. In diesem Fall besitzt also nur eine Arbeitsscheibe eine die Werkstückoberfläche bearbeitende Arbeitsfläche. Das Gegenlagerelement dient dann nur dazu, ein entsprechendes Gegenlager für die Bearbeitung durch die Arbeitsscheibe zu bilden.

Die Werkstücke können zur Bearbeitung in an sich bekannter Weise in Öffnungen von in dem Arbeitsspalt angeordneten Läuferscheiben schwimmend aufgenommen werden. Die erste Arbeitsscheibe und das Gegenlagerelement werden im Betrieb relativ zueinander drehend angetrieben, beispielsweise über eine erste und/oder eine zweite Antriebswelle und mindestens einen Antriebsmotor. Es können dabei sowohl das Gegenlagerelement als auch die erste Arbeitsscheibe drehend angetrieben werden, zum Beispiel gegenläufig. Es ist aber auch möglich, nur eines von Gegenlagerelement und erster Arbeitsscheibe drehend anzutreiben. Beispielsweise bei einer Doppelseitenbearbeitungsmaschine können durch eine geeignete Kinematik Läuferscheiben im Zuge dieser Relativdrehung ebenfalls drehend durch den Arbeitsspalt bewegt, sodass in den Läuferscheiben angeordnete Werkstücke zykloide Bahnen in dem Arbeitsspalt beschreiben. Beispielsweise können die Läuferscheiben an ihrem äußeren Rand und/oder an ihrem inneren Rand eine Verzahnung aufweisen, die in eine zugeordnete Verzahnung zum Beispiel der ersten Arbeitsscheibe eingreift. Solche Maschinen mit einer sogenannten Planetenkinematik sind an sich bekannt.

Die erste Arbeitsscheibe kann ringförmig ausgebildet sein. Auch das Gegenlagerelement bzw. die zweite Arbeitsscheibe kann ringförmig ausgebildet sein. Die erste Arbeitsscheibe und das Gegenlagerelement, beispielsweise die zweite Arbeitsscheibe, besitzen dann einander gegenüberliegende, ringförmige Arbeitsflächen, zwischen denen der ringförmige Arbeitsspalt gebildet ist. Die Arbeitsflächen können mit einem Arbeitsbelag, zum Beispiel Poliertüchern, bedeckt sein. Auch etwaige die Arbeitsscheiben haltenden Trägerscheiben können ringförmig ausgebildet sein oder zumindest ringförmige Trägerabschnitte besitzen, an denen die Arbeitsscheiben befestigt sind. Es können auch mehr als eine Trägerscheibe pro Arbeitsscheibe vorgesehen sein.

Zwischen der ersten Trägerscheibe und der ersten Arbeitsscheibe ist ein vorzugweise ringförmiges Druckvolumen ausgebildet. Das Druckvolumen ist mit einer Druckfluidversorgung verbunden, die derart ansteuerbar ist, dass in dem Druckvolumen ein Druck aufgebaut wird, der eine vorgegebene lokale Verformung der ersten Arbeitsscheibe erzeugt. Soweit in dieser Anmeldung der Begriff Fluid verwendet wird, kann dies sowohl ein Gas als auch eine Flüssigkeit bezeichnen. Bei dem Druckfluid kann es sich um eine Flüssigkeit, insbesondere Wasser, handeln. Durch Einleiten des Druckfluids in das Druckvolumen kann auf die im Vergleich zur Trägerscheibe dünne Arbeitsscheibe ein Druck ausgeübt werden, der zu einer Verformung der Arbeitsscheibe führt. Insbesondere kann auf diese Weise die Arbeitsscheibe durch Einstellen eines niedrigen Drucks in dem Druckvolumen in eine lokal konkave Form gebracht werden, durch Einstellen eines mittleren Drucks in eine lokal plane Form gebracht werden und durch Einstellen eines hohen Drucks in eine lokal konvexe Form gebracht werden. Die lokal konvexe bzw. konkave Verformung bzw. Form liegt dabei insbesondere in radialer Richtung zwischen dem inneren und äußeren Rand der ringförmigen ersten Arbeitsscheibe vor. Das Druckvolumen ist ein veränderliches Druckvolumen. Die erste Arbeitsscheibe bildet mithin eine Membran, die sich abhängig von dem durch unterschiedlichen Druck verursachten Volumen des Druckvolumens verformt.

Die Druckfluidversorgung umfasst ein Druckfluidreservoir, mit dem mindestens eine mit dem Druckvolumen verbundene Druckleitung verbunden ist. In der Druckleitung können eine Pumpe und ein Steuerventil angeordnet sein, die zum Aufbauen des gewünschten Drucks in dem Druckvolumen angesteuert werden können, beispielsweise von einer Steuer- und/oder Regeleinrichtung. Außerdem kann die Druckfluidversorgung eine Druckmesseinrichtung umfassen, die den Druck in dem Druckvolumen direkt oder indirekt misst und deren Messdaten ebenfalls an einer Steuer- und/oder Regeleinrichtung anliegen können. Auf dieser Grundlage kann durch geeignete Ansteuerung der Druckfluidversorgung in dem Druckvolumen der für die gewünschte Arbeitsspaltgeometrie erforderliche Druck eingestellt werden. Gewünscht ist beispielsweise ein über die gesamte radiale Ausdehnung möglichst gleichbleibender Abstand zwischen den Arbeitsscheiben. Die Einstellung der gewünschten Spaltgeometrie kann im statischen Betrieb und/oder im dynamischen Betrieb, also während der Bearbeitung eines Werkstücks, erfolgen.

Mit dem Druckvolumen ist im Wesentlichen eine stufenlose Einstellung der lokalen Form der ersten Arbeitsscheibe zwischen einer durch die Einbau-, Geometrie-, und Materialrandbedingungen vorgegebenen maximal konkaven und maximal konvexen Form möglich. Die erste Arbeitsscheibe kann grundsätzlich eine beliebige Dicke besitzen. Je nach dem gewünschten Verstellbereich der Scheibengeometrie besitzt die Arbeitsscheibe eine geeignete Dicke, so dass sie abhängig von ihrer Flächenausdehnung, insbesondere ihrer Ringbreite bzw. ihrem Bahnradius, mit dem jeweils verfügbaren Druck verformt werden kann. Wie in der DE 10 2016 102 223 A1 erläutert, kann durch die Möglichkeit, die lokale Geometrie der ersten Arbeitsscheibe in radialer Richtung einzustellen, eine Veränderung des Spaltes durch Temperatureinfluss während der Bearbeitung kompensiert werden.

Weiterhin sind Temperierkanäle zum Temperieren der ersten Arbeitsscheibe vorgesehen, wobei die Temperierkanäle innerhalb der Arbeitsscheibe angeordnet sind, so dass die Temperierkanäle näher an dem Arbeitsspalt angeordnet sind als das Druckvolumen. Die Temperierkanäle sind zum Durchleiten eines Temperierfluids ausgebildet. Sie können zum Beispiel labyrinthartig ausgebildet sein. Durch die Temperierkanäle wird im Betrieb der Maschine ein Temperierfluid, zum Beispiel eine Temperierflüssigkeit, wie Wasser, zum Temperieren, insbesondere Kühlen, der Arbeitsscheibe geleitet. Durch die Temperierkanäle kann einer wärmebedingten Verformung der Arbeitsscheibe bis zu einem gewissen Grad entgegengewirkt werden.

Durch die erfindungsgemäße Anordnung der Temperierkanäle innerhalb der ersten Arbeitsscheibe, insbesondere ausschließlich innerhalb der ersten Arbeitsscheibe können die Temperierkanäle anders als im Stand der Technik näher an dem Arbeitsspalt angeordnet sein als das Druckvolumen. Durch die Trägerscheibe kann dabei insbesondere nur eine Zu- und Ableitung für das Temperierfluid verlaufen, die mit der Temperierfluidversorgung verbunden sind. Durch die näher am Arbeitsspalt angeordneten Temperierkanäle erfolgt eine effektivere Kühlung der ersten Arbeitsscheibe, so dass insbesondere die oben erläuterten Probleme einer stärkeren Erwärmung der Arbeitsscheibe als der Trägerscheibe und einer stärkeren Erwärmung einer den Arbeitsspalt begrenzenden Seite der Arbeitsscheibe vermieden werden können. Entsprechende Verspannungen zwischen der ersten Arbeitsscheibe und der ersten Trägerscheibe bzw. unerwünschte Verformungen der ersten Arbeitsscheibe können vermieden werden. Vielmehr befinden sich die Temperierkanäle so nah an der den Arbeitsspalt begrenzenden Oberfläche der Arbeitsscheibe wie möglich, so dass ein Eindringen der Prozesswärme durch die Arbeitsscheibe hindurch in die Trägerscheibe weitestgehend verhindert werden kann. Um den Wärmeübergang zwischen erster Arbeitsscheibe und erster Trägerscheibe weiter zu minimieren, ist es möglich, die erste Trägerscheibe und/oder die erste Arbeitsscheibe im Bereich ihres Kontakts mit Stegen oder anderen Erhebungen zu versehen, so dass die Kontaktfläche zwischen den Scheiben minimiert wird.

Darüber hinaus stehen erfindungsgemäß die Temperierkanäle nicht in Verbindung mit dem Druckvolumen, ebenfalls anders als im Stand der Technik, wo diese miteinander in Verbindung stehen und einen gemeinsamen Kreislauf bilden. Bei der Erfindung sind also getrennte Fluidsysteme (Kreisläufe) für die Temperierkanäle einerseits und für das Druckvolumen andererseits vorgesehen. Dadurch ist eine flexiblere Einstellung des Drucks in dem Druckvolumen unabhängig von dem Druck in den Temperierkanälen möglich. Auch wird der für das Einstellen der lokalen Geometrie nutzbare Druck in dem Druckvolumen im Gegensatz zum Stand der Technik nicht durch den Druck in den Temperierkanälen begrenzt.

Nach einer Ausgestaltung kann das Gegenlagerelement durch eine vorzugsweise ringförmige zweite Arbeitsscheibe gebildet sein, wobei die Arbeitsscheiben koaxial zueinander angeordnet sind, und wobei zwischen den Arbeitsscheiben der Arbeitsspalt zur weiteren einseitigen Bearbeitung flacher Werkstücke gebildet ist. Es handelt sich also insbesondere um eine Doppelseiten-Bearbeitungsmaschine. Die zweite Arbeitsscheibe kann an einer zweiten Trägerscheibe befestigt sein. Sie kann auch ein Druckvolumen und/oder Temperierkanäle aufweisen, wie dies zur ersten Arbeitsscheibe und der ersten Trägerscheibe erläutert wurde. Zwingend ist dies jedoch nicht.

Nach einer weiteren Ausgestaltung kann die erste Arbeitsscheibe aus zwei miteinander verbundenen, vorzugsweise ringförmigen Scheiben gebildet sein, zwischen denen die Temperierkanäle ausgebildet sind, wobei eine der Scheiben den Arbeitsspalt begrenzt. Die erste Arbeitsscheibe ist somit zweiteilig aufgebaut, wobei sie ähnlich einer Sandwich-Konstruktion zwischen den beiden Teilscheiben die Temperierkanäle ausbildet. Durch diese Ausgestaltung ist das Ausbilden der Temperierkanäle ausschließlich innerhalb der ersten Arbeitsscheibe konstruktiv besonders gut möglich. Gemäß einer besonders praxisgemäßen Ausgestaltung können die beiden Scheiben miteinander verschraubt sein. Es sind aber natürlich auch andere Befestigungsmöglichkeiten denkbar.

Die erste Trägerscheibe kann mit der ersten Arbeitsscheibe ebenfalls verschraubt sein. Es sind aber wiederum auch andere Befestigungsmöglichkeiten denkbar. Gleiches gilt gegebenenfalls für eine zweite Arbeitsscheibe und eine zweite Trägerscheibe.

Zum Erreichen einer besonders effektiven Temperierung, insbesondere Kühlung, können die Temperierkanäle ein in der ersten Arbeitsscheibe ausgebildetes Kanallabyrinth bilden. Die Temperierkanäle können beispielsweise durch fräsende Bearbeitung in die erste Arbeitsscheibe, beispielsweise eine oder zwei, die erste Arbeitsscheibe bildende Scheiben, eingebracht sein.

Nach einer weiteren Ausgestaltung kann die Druckfluidversorgung Druckfluid durch eine mit der ersten Trägerscheibe verbundene Antriebswelle zuführen und/oder kann die Temperierfluidversorgung Temperierfluid durch eine mit der ersten Trägerscheibe verbundene Antriebswelle zu- und abführen. Die Zuführung des Druckvolumens ist dabei getrennt von der Zu- und Abführung der Temperierkanäle. Vorteilhaft bei der Zu- und Abführung über eine Antriebswelle ist, dass nur ein Übergang zwischen dem rotierenden und dem feststehenden System erforderlich ist.

Nach einer weiteren Ausgestaltung kann eine Abstandsmesseinrichtung vorgesehen sein zum Bestimmen der Arbeitsspaltdicke und/oder der Arbeitsscheibenverformung. Die Abstandsmesseinrichtung kann mindestens einen Abstandsmesssensor umfassen, der an mindestens einem Ort des Arbeitsspaltes die Arbeitsspaltdicke und/oder die Arbeitsscheibenverformung misst. Beispielsweise kann der mindestens eine Abstandsmesssensor den Abstand zwischen der ersten Arbeitsscheibe und einer die in diesem Fall als Membran wirkende erste Arbeitsscheibe haltenden Trägerscheibe messen. Der Abstandsmesssensor wird dann bevorzugt am Radius der maximalen lokalen Verformung der ersten Arbeitsscheibe angeordnet, insbesondere in der Mitte der Arbeitsscheibe. Der Abstandsmesssensor kann auch den Abstand zwischen der ersten Arbeitsscheibe und dem Gegenlagerelement bzw. zwischen den Arbeitsscheiben messen und beispielsweise in der zweiten Arbeitsscheibe angeordnet sein.

Die Abstandsmesseinrichtung kann weiterhin mindestens zwei Abstandssensoren umfassen, die an mindestens zwei radial beabstandeten Orten die Arbeitsspaltdicke messen. Beispielsweise können die Abstandsmesssensoren den Abstand zwischen der ersten Arbeitsscheibe und dem Gegenlagerelement bzw. den Abstand zwischen den Arbeitsscheiben messen. Die Abstandssensoren können beispielsweise im Bereich eines Randes des Arbeitsspalts und in der Mitte des Arbeitsspalts angeordnet sein. Um eine noch bessere Vermessung der Arbeitsspaltgeometrie zu erreichen, kann die Abstandsmesseinrichtung nach einer weiteren Ausgestaltung mindestens drei Abstandsmesssensoren umfassen, die an mindestens drei radial beabstandeten Punkten des Arbeitsspaltes die Arbeitsspaltdicke messen. In diesem Fall können Abstandssensoren den Abstand zum Beispiel jeweils an dem inneren und äußeren Rand sowie in der Mitte des Arbeitsspalts messen. Es ist dabei möglich, dass sämtliche Abstandsmesssensoren den Abstand zwischen der ersten Arbeitsscheibe und dem Gegenlagerelement bzw. zwischen den Arbeitsscheiben messen und beispielsweise in der zweiten Arbeitsscheibe angeordnet sind. Es ist aber auch eine Kombination der oben erläuterten Ausgestaltungen der Abstandsmesseinrichtung möglich, bei der beispielsweise am inneren und äußeren Rand Abstandsmesssensoren den Abstand zwischen der ersten Arbeitsscheibe und dem Gegenlagerelement bzw. den Abstand zwischen den Arbeitsscheiben messen, und bei dem ein Abstandsmesssensor in der Mitte des Arbeitsspalt den Abstand zwischen der ersten Arbeitsscheibe und einer die erste Arbeitsscheibe haltenden ersten Trägerscheibe misst.

Die Abstandsmesseinrichtung kann nach einer weiteren Ausgestaltung mindestens einen in der ersten Trägerscheibe angeordneten Abstandsmesssensor aufweisen, der den Abstand zu einer Oberseite des Druckvolumens misst. Mit einem solchen Sensor kann zum Beispiel eine radiale Verformung der ersten Arbeitsscheibe erfasst werden. Der Sensor kann in unterschiedlicher Form realisiert sein. Beispielsweise kann es sich um einen optischen Sensor, einen mechanischen Sensor, einen induktiven Sensor oder einen Wirbelstromsensor handeln.

Nach einer weiteren Ausgestaltung kann eine Steuer- und/oder Regeleinrichtung vorgesehen sein, die in Abhängigkeit von den von der Abstandsmesseinrichtung erhaltenen Messdaten die Druckfluidversorgung so ansteuert, dass eine vorgegebene Geometrie der ersten Arbeitsscheibe bewirkt wird. Insbesondere kann die Steuer-und/oder Regeleinrichtung die Druckfluidversorgung ansteuern, um in dem Druckvolumen einen Druck zu erzeugen, der eine vorgegebene lokale Verformung der ersten Arbeitsscheibe bewirkt. Das lokale Verformen der ersten Arbeitsscheibe wird bei dieser Ausgestaltung von einer Steuer- und/oder Regeleinrichtung gesteuert bzw. geregelt, an deren Eingang die Messdaten der Abstandsmesseinrichtung anliegen. Stellt die Steuer- und/oder Regeleinrichtung aufgrund der von der Abstandsmesseinrichtung gemessenen Werte eine Abweichung der Arbeitsspaltgeometrie von einer vorgegebenen Geometrie fest, so steuert sie die Druckfluidversorgung so an, dass der Arbeitsspalt möglichst wieder die vorgegebene Geometrie annimmt. Diese erfindungsgemäße Steuerung- und/oder Regelung kann insbesondere automatisch während des Produktionsbetriebs der Doppel- oder Einseiten-Bearbeitungsmaschine erfolgen. Über die Versorgung der Temperierkanäle mit Temperierfluid wird darüber hinaus einer unerwünschten Verformung der Arbeitsscheibe(n) entgegengewirkt. Auch dies kann durch die Steuer- und/oder Regeleinrichtung erfolgen. Beispielsweise kann die Steuer-und/oder Regeleinrichtung durch geeignete Temperierung des Temperierfluids auf eine vorgegebene Temperatur am Eingang und/oder am Ausgang der Temperierkanäle oder auf eine vorgegebene Temperaturdifferenz zwischen der am Eingang und der am Ausgang der Temperierkanäle vorliegenden Temperatur regeln.

Es können weiterhin Mittel zum Erzeugen einer globalen Verformung des Gegenlagerelements, insbesondere der zweiten Arbeitsscheibe, vorgesehen sein. Die Steuer- und/oder Regeleinrichtung kann dazu ausgebildet sein, auch die Mittel zum Verformen des Gegenlagerelements anzusteuern. Die Ansteuerung durch die Steuer-und/oder Regeleinrichtung kann wiederum in Abhängigkeit von den von der Abstandsmesseinrichtung erhaltenen Messdaten erfolgen.

Sind mindestens drei Abstandsmesssensoren vorgesehen, die an mindestens drei radial beabstandeten Punkten des Arbeitsspalts den Abstand messen, kann durch einen Abgleich der an dem inneren und äußeren Rand des Arbeitsspalts vorgesehenen Abstandsmesssensoren die globale Einstellung des Arbeitsspalts durch eine globale Verformung der zweiten Arbeitsscheibe erfolgen. Der zwischen den inneren und äußeren Abstandsmesssensoren angeordnete dritte, mittlere Abstandsmesssensor überwacht dabei die Planarität der Arbeitsscheiben in radialer Richtung zwischen dem inneren und äußeren Rand der Arbeitsscheiben, also eine etwaige Abweichung von einer planen Ebene in radialer Richtung. Durch geeignete lokale Verformung der ersten Arbeitsscheibe kann auch diese lokale Parallelität optimal eingestellt werden. Ziel ist es, die von allen Abstandsmesssensoren gemessenen Abstandswerte durch geeignete Verformung der ersten Arbeitsscheibe und/oder der zweiten Arbeitsscheibe so einzustellen, dass die jeweils gewünschten Zielwerte für den Arbeitsspalt und die Planarität bzw. Abweichung von dieser zum Erzielen eines optimalen Arbeitsergebnisses erreicht werden.

Nach einer weiteren Ausgestaltung kann vorgesehen sein, dass das Gegenlagerelement eine an einer zweiten Trägerscheibe befestigte zweite Arbeitsscheibe ist, und dass die Mittel zum Verformen der zweiten Arbeitsscheibe einen Tragring umfassen, an dem die zweite Trägerscheibe aufgehängt ist, wobei zwischen dem Tragring und einem radial außen vom Tragring liegenden Ringabschnitt der zweiten Trägerscheibe steuerbare Mittel angeordnet sind, über die mit Hilfe eines Krafterzeugers eine radiale Kraft über den Umfang des Tragrings auf die zweite Trägerscheibe aufgebracht wird, wobei die Steuer- und/oder Regeleinrichtung in Abhängigkeit von den von der Abstandsmesseinrichtung gemessenen Abstandswerten oder von den von einer Messeinrichtung gemessenen Druckwerten die Kraft am Krafterzeuger einstellt. Der Tragring kann dabei drehfest mit einer oberen Arbeitswelle zum drehenden Antreiben der zweiten Träger- und Arbeitsscheibe verbunden sein.

Weiterhin kann vorgesehen sein, dass zwischen dem Tragring und dem Ringabschnitt ein in Umfangsrichtung umlaufender Ringkanal geringer Breite ausgebildet ist und der Krafterzeuger ein Druckerzeuger ist, der mit dem Ringkanal verbunden ist und einen vorgegebenen Druck im Ringkanal erzeugt.

Auch kann vorgesehen sein, dass auf dem Tragring ein Zylinder mit einem Kolben angeordnet ist, der Kolben mit einer Zylinderbohrung im Tragring zusammenwirkt, die über eine Querbohrung mit dem Ringkanal verbunden ist und im Ringkanal und in der Zylinderbohrung ein Hydraulikmedium aufgenommen ist. Der Kolben kann von einem steuerbaren Druck einer Hydraulikquelle betätigbar sein. Insbesondere kann eine hydropneumatische Ansteuerung erfolgen.

Die vorgenannten Ausgestaltungen zur globalen Verformung der Arbeitsscheibe sind grundsätzlich bekannt aus DE 10 2006 037 490 B4 und können bei der vorliegenden Erfindung in entsprechender Weise zur Anwendung kommen.

Nach einer weiteren Ausgestaltung kann vorgesehen sein, dass die erste Arbeitsscheibe nur im Bereich ihres äußeren Randes und im Bereich ihres inneren Randes an der ersten Trägerscheibe befestigt ist. Wie bereits erläutert, können die Arbeitsscheiben insbesondere ringförmig sein. Zwischen der ersten Arbeitsscheibe und der ersten Trägerscheibe ist dann das vorzugsweise ringförmige Druckvolumen gebildet. Die erste Arbeitsscheibe ist bei der vorgenannten Ausgestaltung nur im Bereich ihres die Arbeitsfläche begrenzenden radial äußeren und radial inneren Randes an der ersten Trägerscheibe befestigt, beispielsweise jeweils entlang eines Teilkreises verschraubt. Zwischen diesen Randbereichen ist die Arbeitsscheibe dagegen nicht an der Trägerscheibe befestigt. Insbesondere in diesem Bereich kann das Druckvolumen gebildet sein. Auf diese Weise besitzt die Arbeitsscheibe die erforderliche Beweglichkeit, um durch Aufbauen eines geeigneten Drucks in dem Druckvolumen in der gewünschten Weise verformt zu werden. Dabei ist die Befestigung der Arbeitsscheibe an der Trägerscheibe so gewählt, dass die Auflagefläche am inneren und äußeren Rand möglichst schmal gehalten ist, um eine gezielte Verformung über möglichst die gesamte Oberfläche der Arbeitsscheibe zu erreichen.

Ausführungsbeispiele der Erfindung werden nachfolgend anhand von Figuren näher erläutert. Es zeigen schematisch:
- Figur 1: einen Teil einer erfindungsgemäßen Doppelseiten-Bearbeitungsmaschine in einer Schnittansicht nach einem ersten Ausführungsbeispiel,
- Figur 2: einen Teil einer erfindungsgemäßen Doppelseiten-Bearbeitungsmaschine in einer Schnittansicht nach einem zweiten Ausführungsbeispiel, und
- Figur 3: einen Teil einer erfindungsgemäßen Doppelseiten-Bearbeitungsmaschine in einer Schnittansicht nach einem dritten Ausführungsbeispiel.

Soweit nichts anderes angegeben ist, bezeichnen in den Figuren gleiche Bezugszeichen gleiche Gegenstände.

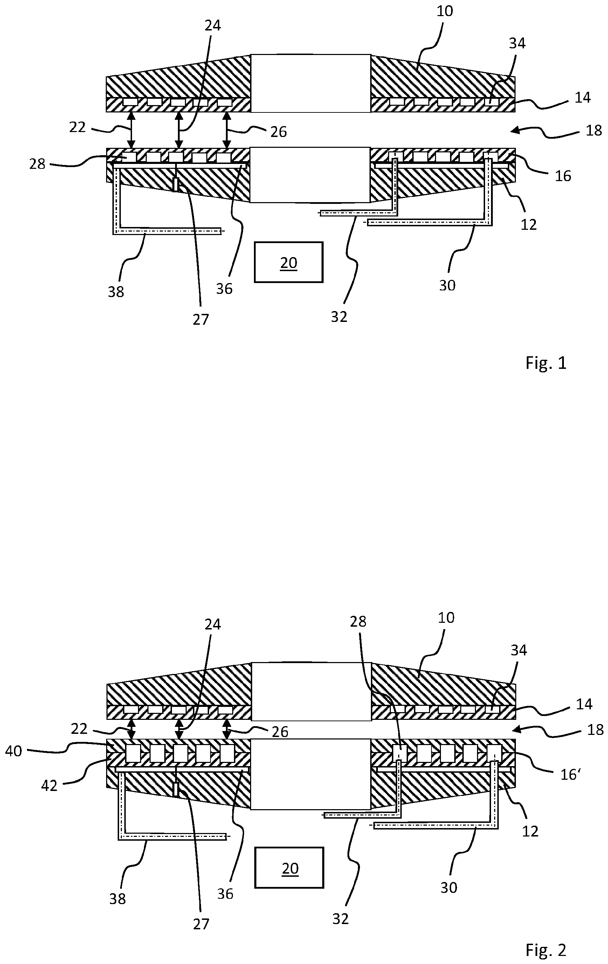

Die in Figur 1 lediglich beispielhaft dargestellte Doppelseiten-Bearbeitungsmaschine weist eine ringförmige erste, untere Trägerscheibe 12 und eine ebenfalls ringförmige zweite, obere Trägerscheibe 10 auf. An der unteren Trägerscheibe 12 ist eine ringförmige erste, untere Arbeitsscheibe 16 befestigt und an der oberen Trägerscheibe 10 ist eine ebenfalls ringförmige zweite, obere Arbeitsscheibe 14 befestigt. Zwischen den ringförmigen Arbeitsscheiben 14, 16 ist ein ringförmiger Arbeitsspalt 18 gebildet, in dem im Betrieb flache Werkstücke, beispielsweise Wafer, beidseitig bearbeitet werden. Bei der Doppelseiten-Bearbeitungsmaschine kann es sich beispielsweise um eine Poliermaschine, eine Läppmaschine oder eine Schleifmaschine handeln.

Die obere Trägerscheibe 10 und mit ihr die obere Arbeitsscheibe 14 und/oder die untere Trägerscheibe 12 und mit ihr die untere Arbeitsscheibe 16 können durch eine geeignete Antriebseinrichtung, umfassend beispielsweise eine obere Antriebswelle und/oder eine untere Antriebswelle sowie mindestens einen Antriebsmotor relativ zueinander drehend angetrieben werden. Die Antriebseinrichtung ist an sich bekannt und aus Gründen der Übersichtlichkeit nicht näher dargestellt. In ebenfalls an sich bekannter Weise können zu bearbeitende Werkstücke schwimmend in Läuferscheiben in dem Arbeitsspalt 18 gehalten werden. Durch eine geeignete Kinematik, beispielsweise eine Planetenkinematik, kann sichergestellt werden, dass sich die Läuferscheiben im Zuge der Relativdrehung der Trägerscheiben 10, 12 bzw. Arbeitsscheiben 14, 16 ebenfalls durch den Arbeitsspalt 18 drehen. Eine Steuer-und/oder Regeleinrichtung 20 steuert bzw. regelt den Betrieb der DoppelseitenBearbeitungsmaschine. Außerdem sind im dargestellten Beispiel drei durch Pfeile 22, 24, 26 veranschaulichte Abstandsmesssensoren vorgesehen, die an drei radial beabstandeten Punkten des Arbeitsspalts 18 den Abstand zwischen den Arbeitsscheiben 14, 16 messen. Die Messdaten der Abstandsmesssensoren 22, 24, 26 werden der Steuer- und/oder Regeleinrichtung 20 zur Verfügung gestellt, die diese Messdaten zur Steuerung bzw. Regelung der Doppelseiten-Bearbeitungsmaschine verwendet.

In dem in Figur 1 gezeigten Beispiel sind innerhalb der unteren Arbeitsscheibe 16 labyrinthartig ausgebildete Temperierkanäle 28 vorgesehen. Die Temperierkanäle 28 sind über eine Zuführung 30 und eine Abführung 32 beispielsweise über eine die untere Trägerscheibe 12 und die untere Arbeitsscheibe 16 antreibende Antriebswelle mit einer Temperierfluidversorgung verbunden. Durch die Steuer- und/oder Regeleinrichtung 20 kann zum Beispiel auf einen vorgegebenen Temperaturwert des Temperierfluids am Eingang und/oder am Ausgang der Temperierkanäle oder auf eine vorgegebene Temperaturdifferenz zwischen der am Eingang und der am Ausgang der Temperierkanäle vorliegenden Temperatur geregelt werden, indem die Temperatur des Temperierfluids entsprechend eingestellt wird.. In dem gezeigten Beispiel sind auch in der oberen Arbeitsscheibe 14 labyrinthartige Temperierkanäle 34 ausgebildet, die über eine nicht näher dargestellte Zuführung und Abführung ebenfalls mit einer Temperierfluidversorgung verbunden sind. Auch diese Temperierfluidversorgung wird durch die Steuer- und/oder Regeleinrichtung 20 gesteuert. Durch Versorgung der Temperierkanäle 28 bzw. 34 mit einem Temperierfluid, beispielsweise einer Kühlflüssigkeit, wie Wasser, kann einer Erwärmung der Arbeitsscheiben 14, 16 und einem Wärmeübergang in die Trägerscheiben 10, 12 effektiv entgegengewirkt werden, so dass entsprechende Geometrieänderungen verringert werden.

Außerdem ist zwischen der unteren Trägerscheibe 12 und der unteren Arbeitsscheibe 16 ein in dem gezeigten Beispiel ringförmiges Druckvolumen 36 ausgebildet, das über eine Zuführung 38, beispielsweise ebenfalls über eine die untere Trägerscheibe 12 und die untere Arbeitsscheibe 16 antreibende Antriebswelle mit einer Druckfluidversorgung verbunden ist. Zusätzlich ist ein weiterer Abstandsmesssensor 27 in der unteren Trägerscheibe 10 angeordnet, der den Abstand zu der Oberseite des Druckvolumens 36 misst. Auch die Messdaten dieses Abstandsmesssensors 27 liegen an der Steuer- und/oder Regeleinrichtung 20 an. Die Druckfluidversorgung wird ebenfalls von der Steuer- und/oder Regeleinrichtung 20 angesteuert. Durch entsprechendes Einleiten von Druckfluid in das Druckvolumen 28 kann eine lokale Verformung der unteren Arbeitsscheibe 16 erzeugt werden, insbesondere eine lokale konkave oder konvexe Verformung, wie dies grundsätzlich in der DE 10 2016 102 223 A1 beschrieben ist.

Wie in Figur 1 zu erkennen, sind die Temperierkanäle 28 näher am Arbeitsspalt 18 angeordnet als das Druckvolumen 36. Außerdem stehen die Leitungssysteme des Druckvolumens 36 und der Temperierkanäle 28 nicht miteinander in Verbindung, sondern sind getrennt steuer- bzw. regelbar.

Das in Figur 2 dargestellte Ausführungsbeispiel entspricht weitgehend dem in Figur 1 dargestellten Ausführungsbeispiel. Es unterscheidet sich lediglich in der Ausbildung der unteren Arbeitsscheibe 16', die in dem in Figur 2 gezeigten Beispiel aus zwei ringförmigen, miteinander befestigten Scheiben 40, 42 gebildet ist. Die Temperierkanäle 28 sind nach Art einer Sandwich-Konstruktion zwischen den Scheiben 40, 42 ausgebildet. Auf diese Weise kann eine besonders effektive Temperierung der unteren Arbeitsscheibe 16' erfolgen.

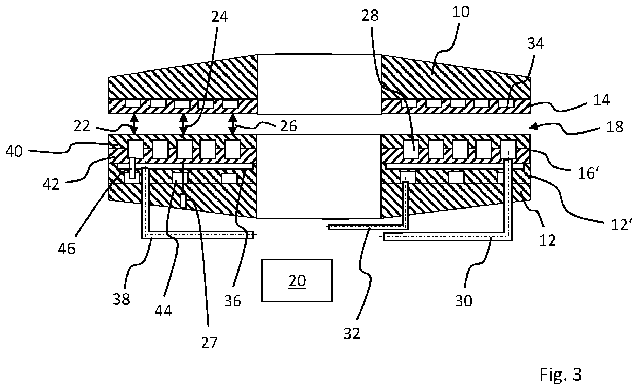

Das in Figur 3 dargestellte Ausführungsbeispiel entspricht wiederum weitgehend dem in Figur 2 dargestellten Ausführungsbeispiel, wobei im Unterschied zu dem Ausführungsbeispiel nach Figur 2 zwischen der unteren Trägerscheibe 12 und der unteren Arbeitsscheibe 16' eine weitere untere Trägerscheibe 12' angeordnet ist, die einerseits mit der unteren Trägerscheibe 12 und andererseits mit der unteren Arbeitsscheibe 16' verbunden ist. Bei dem Ausführungsbeispiel nach Figur 3 sind in der die untere Arbeitsscheibe 16' tragenden unteren Trägerscheibe 12' ebenfalls labyrinthartige Temperierkanäle 44 ausgebildet, die über eine Verbindungsleitung 46 mit den in der unteren Arbeitsscheibe 16' ausgebildeten Temperierkanälen 28 verbunden sind und über dieselbe Zuführung 30 und Abführung 32 mit der Temperierfluidversorgung verbunden sind. Durch diese zusätzlichen Temperierkanäle 44 in der unteren Trägerscheibe 12' wird eine Wärmeübertragung von der unteren Arbeitsscheibe 16' auf die untere Trägerscheibe 12 noch effektiver verhindert.

### Bezugszeichenliste

- 10: zweite Trägerscheibe
- 12: erste Trägerscheibe
- 12': erste Trägerscheibe
- 14: zweite Arbeitsscheibe
- 16: erste Arbeitsscheibe
- 16': erste Arbeitsscheibe
- 18: Arbeitsspalt
- 20: Steuer- und/oder Regeleinrichtung
- 22: Abstandsmesssensor
- 24: Abstandsmesssensor
- 26: Abstandsmesssensor
- 27: Abstandsmesssensor
- 28: Temperierkanäle
- 30: Zuführung
- 32: Abführung
- 34: Temperierkanäle
- 36: Druckvolumen
- 38: Zuführung
- 40: Scheibe
- 42: Scheibe
- 44: Temperierkanäle
- 46: Verbindungsleitung

## Patentansprüche

1. Doppel- oder Einseiten-Bearbeitungsmaschine mit einer vorzugsweise ringförmigen ersten Arbeitsscheibe (16, 16'), die an einer ersten Trägerscheibe (12, 12') befestigt ist, und mit einem Gegenlagerelement, wobei die erste Arbeitsscheibe (16, 16') und das Gegenlagerelement über mindestens eine Antriebswelle relativ zueinander drehend antreibbar sind, wobei zwischen der ersten Arbeitsscheibe (16, 16') und dem Gegenlagerelement ein Arbeitsspalt (18) zum beid- oder einseitigen Bearbeiten flacher Werkstücke gebildet ist, wobei zwischen der ersten Trägerscheibe (12, 12') und der ersten Arbeitsscheibe (16, 16') ein Druckvolumen (36) angeordnet ist, das mit einer Druckfluidversorgung verbunden ist, die derart ansteuerbar ist, dass in dem Druckvolumen (36) ein Druck aufgebaut wird, der eine vorgegebene Verformung der ersten Arbeitsscheibe (16, 16') erzeugt, und wobei Temperierkanäle (28) zum Temperieren der ersten Arbeitsscheibe (16, 16') vorgesehen sind, die mit einer Temperierfluidversorgung verbunden sind, **dadurch gekennzeichnet, dass** die Temperierkanäle (28) innerhalb der ersten Arbeitsscheibe (16, 16') angeordnet sind, so dass die Temperierkanäle (28) näher an dem Arbeitsspalt (18) angeordnet sind als das Druckvolumen (36), und dass die Temperierkanäle (28) nicht in Verbindung mit dem Druckvolumen (36) stehen.

2. Doppel- oder Einseiten-Bearbeitungsmaschine nach Anspruch 1, **dadurch gekennzeichnet, dass** das Gegenlagerelement durch eine vorzugsweise ringförmige zweite Arbeitsscheibe (14) gebildet ist, wobei die erste und zweite Arbeitsscheibe (14, 16, 16') koaxial zueinander angeordnet sind, wobei zwischen der ersten und zweiten Arbeitsscheibe (14, 16, 16') der Arbeitsspalt (18) zum beid- oder einseitigen Bearbeiten flacher Werkstücke gebildet ist.

3. Doppel- oder Einseiten-Bearbeitungsmaschine nach einem der vorhergehenden Ansprüche, **dadurch gekennzeichnet, dass** die erste Arbeitsscheibe (16, 16') aus zwei miteinander verbundenen, vorzugsweise ringförmigen Scheiben (40, 42) gebildet ist, zwischen denen die Temperierkanäle (28) ausgebildet sind, wobei eine der Scheiben (40, 42) den Arbeitsspalt (18) begrenzt.

4. Doppel- oder Einseiten-Bearbeitungsmaschine nach einem der vorhergehenden Ansprüche, **dadurch gekennzeichnet, dass** die Temperierkanäle (28) ein in der ersten Arbeitsscheibe (16, 16') ausgebildetes Kanallabyrinth bilden.

5. Doppel- oder Einseiten-Bearbeitungsmaschine nach einem der vorhergehenden Ansprüche, **dadurch gekennzeichnet, dass** die Druckfluidversorgung Druckfluid durch eine mit der ersten Trägerscheibe (12, 12') verbundene Antriebswelle zuführt und/oder dass die Temperierfluidversorgung Temperierfluid durch eine mit der ersten Trägerscheibe (12, 12') verbundene Antriebswelle zu- und abführt.

6. Doppel- oder Einseiten-Bearbeitungsmaschine nach einem der vorhergehenden Ansprüche, **dadurch gekennzeichnet, dass** weiterhin eine Abstandsmesseinrichtung zum Bestimmen der Arbeitsspaltdicke und/oder der Arbeitsscheibenverformung vorgesehen ist.

7. Doppel- oder Einseiten-Bearbeitungsmaschine nach Anspruch 6, **dadurch gekennzeichnet, dass** die Abstandsmesseinrichtung mindestens einen Abstandsmesssensor (22, 24, 26) umfasst, der an mindestens einem Ort des Arbeitsspaltes (18) den Abstand zwischen der ersten Arbeitsscheibe (16, 16') und einer die erste Arbeitsscheibe (16, 16') haltenden ersten Trägerscheibe (12, 12') misst.

8. Doppel- oder Einseiten-Bearbeitungsmaschine nach einem der Ansprüche 6 oder 7, **dadurch gekennzeichnet, dass** die Abstandsmesseinrichtung mindestens zwei Abstandsmesssensoren (22, 24, 26) umfasst, die an mindestens zwei radial beabstandeten Punkten des Arbeitsspaltes (18) den Abstand zwischen der ersten Arbeitsscheibe (16, 16') und dem Gegenlagerelement messen, vorzugsweise dass die Abstandsmesseinrichtung mindestens drei Abstandsmesssensoren (22, 24, 26) umfasst, die an mindestens drei radial beabstandeten Punkten des Arbeitsspaltes (18) den Abstand zwischen der ersten Arbeitsscheibe (16, 16') und dem Gegenlagerelement messen.

9. Doppel- oder Einseiten-Bearbeitungsmaschine nach einem der Ansprüche 6 bis 8, **dadurch gekennzeichnet, dass** die Abstandsmesseinrichtung mindestens einen in der ersten Trägerscheibe (12, 12') angeordneten Abstandsmesssensor (27) aufweist, der den Abstand zu einer Oberseite des Druckvolumens (26) misst.

10. Doppel- oder Einseiten-Bearbeitungsmaschine nach einem der Ansprüche 6 bis 9, **dadurch gekennzeichnet, dass** eine Steuer- und/oder Regeleinrichtung (20) vorgesehen ist, die in Abhängigkeit von den von der Abstandsmesseinrichtung erhaltenen Messdaten die Druckfluidversorgung so ansteuert, dass eine vorgegebene Geometrie der ersten Arbeitsscheibe (16, 16') bewirkt wird.

11. Doppel- oder Einseiten-Bearbeitungsmaschine nach einem der vorhergehenden Ansprüche, **dadurch gekennzeichnet, dass** weiterhin Mittel zum Erzeugen einer globalen Verformung des Gegenlagerelements vorgesehen sind.

12. Doppel- oder Einseiten-Bearbeitungsmaschine nach den Ansprüchen 10 und 11, **dadurch gekennzeichnet, dass** die Steuer- und/oder Regeleinrichtung (20) dazu ausgebildet ist, auch die Mittel zum Erzeugen der globalen Verformung des Gegenlagerelements anzusteuern.

13. Doppel- oder Einseiten-Bearbeitungsmaschine nach einem der Ansprüche 11 oder 12, **dadurch gekennzeichnet, dass** das Gegenlagerelement eine an einer zweiten Trägerscheibe (10) befestigte zweite Arbeitsscheibe (14) ist, und dass die Mittel zum Verformen der zweiten Arbeitsscheibe (14) einen Tragring umfassen, an dem die zweite Trägerscheibe (10) aufgehängt ist, wobei zwischen dem Tragring und einem radial außen vom Tragring liegenden Ringabschnitt der zweiten Trägerscheibe (10) steuerbare Mittel angeordnet sind, über die mit Hilfe eines Krafterzeugers eine radiale Kraft über den Umfang des Tragrings auf die zweite Trägerscheibe (10) aufgebracht wird, wobei die Steuer- und/oder Regeleinrichtung (20) in Abhängigkeit von den von der Abstandsmesseinrichtung gemessenen Abstandswerten oder von den von einer Messeinrichtung gemessenen Druckwerten die Kraft am Krafterzeuger einstellt.

## Claims

1. A double or single-side machining machine with a preferably annular first working disk (16, 16') which is attached to a first support disk (12, 12'), and with a counter-bearing element, wherein the first working disk (16, 16') and the counter-bearing element can be driven rotationally relative to each other via at least one drive shaft, wherein a working gap (18) for single or double-sided machining of flat workpieces is formed between the first working disk (16, 16') and the counter-bearing element, wherein a pressure volume (36) is arranged between the first support disk (12, 12') and the first working disk (16, 16') and is connected to a pressure fluid supply which can be controlled such that a pressure is built up in the pressure volume (36), which pressure generates a predefined deformation of the first working disk (16, 16'), and wherein tempering channels (28) for tempering the first working disk (16, 16') are provided which are connected to a tempering fluid supply, **characterized in that** the tempering channels (28) are arranged within the first working disk (16, 16') so that the tempering channels (28) are arranged closer to the working gap (18) than the pressure volume (36), and that the tempering channels (28) are not in connection with the pressure volume (36).

2. The double or single-side machining machine according to claim 1, **characterized in that** the counter-bearing element is formed by a preferably annular second working disk (14), wherein the first and second working disks (14, 16, 16') are arranged coaxially to each other, wherein the working gap (18) for double or single-sided machining of flat workpieces is formed between the first and second working disks (14, 16, 16').

3. The double or single-side machining machine according to one of the preceding claims, **characterized in that** the first working disk (16, 16') is formed from two preferably annular disks (40, 42) that are connected to each other, between which the tempering channels (28) are designed, wherein one of the disks (40, 42) delimits the working gap (18).

4. The double or single-side machining machine according to one of the preceding claims, **characterized in that** the tempering channels (28) form a channel labyrinth designed in the first working disk (16, 16').

5. The double or single-side machining machine according to one of the preceding claims, **characterized in that** the pressure fluid supply feeds pressure fluid through a drive shaft connected to the first support disk (12, 12') and/or that the tempering fluid supply feeds and discharges tempering fluid through a drive shaft connected to the first support disk (12, 12').

6. The double or single-side machining machine according to one of the preceding claims, **characterized in that** a distance measuring apparatus for determining the working gap thickness and/or the working disk deformation is also provided.

7. The double or single-side machining machine according to claim 6, **characterized in that** the distance measuring apparatus comprises at least one distance measuring sensor (22, 24, 26) which measures, at at least one location of the working gap (18), the distance between the first working disk (16, 16') and a first support disk (12, 12') holding the first working disk (16, 16').

8. The double or single-side machining machine according to one of claims 6 or 7, **characterized in that** the distance measuring apparatus comprises at least two distance measuring sensors (22, 24, 26) which measure, at at least two points of the working gap (18) which are radially spaced apart from each other, the distance between the first working disk (16, 16') and the counter-bearing element, preferably that the distance measuring apparatus comprises at least three distance measuring sensors (22, 24, 26) which measure, at at least three points of the working gap (18) which are radially spaced apart from each other, the distance between the first working disk (16, 16') and the counter-bearing element.

9. The double or single-side machining machine according to one of claims 6 to 8, **characterized in that** the distance measuring apparatus has at least one distance measuring sensor (27) which is arranged in the first support disk (12, 12') and measures the distance to the top side of the pressure volume (26).

10. The double or single-side machining machine according to one of claims 6 to 9, **characterized in that** a control and/or regulating apparatus (20) is provided which controls the pressure fluid supply depending on the measurement data obtained from the distance measuring apparatus such that a predefined geometry of the first working disk (16, 16') is effected.

11. The double or single-side machining machine according to one of the preceding claims, **characterized in that** means for generating a global deformation of the counter-bearing element are also provided.

12. The double or single-side machining machine according to claims 10 and 11, **characterized in that** the control and/or regulating apparatus (20) is designed to also control the means for generating the global deformation of the counter-bearing element.

13. The double or single-side machining machine according to one of claims 11 or 12, **characterized in that** the counter-bearing element is a second working disk (14) attached to a second support disk (10), and that the means for deforming the second working disk (14) comprise a support ring on which the second support disk (10) is suspended, wherein controllable means are arranged between the support ring and a ring portion of the second support disk (10) lying radially outside the support ring, via which means a radial force is applied to the second support disk (10) over the circumference of the support ring with the aid of a force generator, wherein the control and/or regulating apparatus (20) sets the force on the force generator depending on the distance values measured by the distance measuring apparatus or on the pressure values measured by a measuring apparatus.

## Revendications

1. Machine à usiner double ou simple face, dotée d'un premier disque de travail (16, 16') de préférence annulaire, lequel est fixé à un premier disque de support (12, 12'), et d'un élément de contre-palier, dans laquelle le premier disque de travail (16, 16') et l'élément de contre-palier peuvent être entraînés en rotation l'un par rapport à l'autre par le biais d'au moins un arbre d'entraînement, dans laquelle une fente de travail (18) pour l'usinage double ou simple face de pièces plates est formée entre le premier disque de travail (16, 16') et l'élément de contre-palier, dans laquelle un volume de pression (36) est disposé entre le premier disque de support (12, 12') et le premier disque de travail (16, 16'), lequel est relié à une alimentation en fluide sous pression apte à être actionnée de manière à établir une pression dans le volume de pression (36), laquelle produit une déformation prédéfinie du premier disque de travail (16, 16'), et dans laquelle il est prévu des canaux de tempérage (28) destinés à tempérer le premier disque de travail (16, 16'), lesquels sont reliés à une alimentation en fluide de tempérage, **caractérisée en ce que** les canaux de tempérage (28) sont disposés dans le premier disque de travail (16, 16'), de telle façon que les canaux de tempérage (28) sont disposés plus près de la fente de travail (18) que le volume de pression (36), et **en ce que** les canaux de tempérage (28) ne sont pas reliés au volume de pression (36).

2. Machine à usiner double ou simple face selon la revendication 1, **caractérisée en ce que** l'élément de contre-palier est formé par un deuxième disque de travail (14) de préférence annulaire, dans laquelle le premier et le deuxième disque de travail (14, 16, 16') sont disposés coaxialement l'un par rapport à l'autre, dans laquelle la fente de travail (18) destinée à l'usinage double ou simple face de pièces plates est formée entre le premier et le deuxième disque de travail (14, 16, 16').

3. Machine à usiner double ou simple face selon l'une des revendications précédentes, **caractérisée en ce que** le premier disque de travail (16, 16') est formé par deux disques (40, 42) de préférence annulaires reliés entre eux, entre lesquels sont formés les canaux de tempérage (28), dans laquelle l'un des disques (40, 42) délimite la fente de travail (18).

4. Machine à usiner double ou simple face selon l'une des revendications précédentes, **caractérisée en ce que** les canaux de tempérage (28) forment un labyrinthe de canaux réalisé dans le premier disque de travail (16, 16').

5. Machine à usiner double ou simple face selon l'une des revendications précédentes, **caractérisée en ce que** l'alimentation en fluide sous pression amène du fluide sous pression par le biais d'un arbre d'entraînement relié au premier disque de support (12, 12') et/ou **en ce que** l'alimentation en fluide de tempérage amène et évacue du fluide de tempérage par le biais d'un arbre d'entraînement relié au premier disque de support (12, 12').

6. Machine à usiner double ou simple face selon l'une des revendications précédentes, **caractérisée en ce qu'**il est également prévu un dispositif de mesure de distance destiné à déterminer l'épaisseur de la fente de travail et/ou la déformation du disque de travail.

7. Machine à usiner double ou simple face selon la revendication 6, **caractérisée en ce que** le dispositif de mesure de distance comporte au moins un capteur de mesure de distance (22, 24, 26), lequel mesure, à au moins un endroit de la fente de travail (18), la distance entre le premier disque de travail (16, 16') et un premier disque de support (12, 12') maintenant le premier disque de travail (16, 16').

8. Machine à usiner double ou simple face selon l'une des revendications 6 ou 7, **caractérisée en ce que** le dispositif de mesure de distance comporte au moins deux capteurs de mesure de distance (22, 24, 26), lesquels mesurent la distance entre le premier disque de travail (16, 16') et l'élément de contre-palier en au moins deux points de la fente de travail (18) espacés radialement, **en ce que** le dispositif de mesure de distance comporte avantageusement trois capteurs de mesure de distance (22, 24, 26), lesquels mesurent la distance entre le premier disque de travail (16, 16') et l'élément de contre-palier en au moins trois points de la fente de travail (18) espacés radialement.

9. Machine à usiner double ou simple face selon l'une des revendications 6 à 8, **caractérisée en ce que** le dispositif de mesure de distance présente au moins un capteur de mesure de distance (27) disposé dans le premier disque de support (12, 12'), lequel mesure la distance par rapport à un côté supérieur du volume de pression (36).

10. Machine à usiner double ou simple face selon l'une des revendications 6 à 9, **caractérisée en ce qu'**il est prévu un dispositif de commande et/ou de réglage (20), lequel actionne l'alimentation en fluide sous pression en fonction de données de mesure obtenues à partir du un dispositif de mesure de distance, de manière à créer une géométrie prédéfinie du premier disque de travail (16, 16').

11. Machine à usiner double ou simple face selon l'une des revendications précédentes, **caractérisée en ce qu'**il est également prévu des moyens destinés à produire une déformation globale de l'élément de contre-palier.

12. Machine à usiner double ou simple face selon l'une des revendications 10 et 11, **caractérisée en ce que** le dispositif de commande et/ou de réglage (20) est conçu pour actionner également les moyens destinés à produire une déformation globale de l'élément de contre-palier.

13. Machine à usiner double ou simple face selon l'une des revendications 11 ou 12, **caractérisée en ce que** l'élément de contre-palier est un deuxième disque de travail (14) fixé à un deuxième disque de support (10), et **en ce que** les moyens destinés à déformer le deuxième disque de travail (14) comportent un anneau porteur auquel est suspendu le deuxième disque de support (10), dans laquelle des moyens commandables sont disposés entre l'anneau porteur et une section annulaire du deuxième disque de support (10) située radialement à l'extérieur de l'anneau porteur, par lesquels une force radiale est appliquée au deuxième disque de support (10) par le biais du pourtour de l'anneau porteur à l'aide d'un générateur de force, dans laquelle le dispositif de commande et/ou de réglage (20) règle la force sur le générateur de force en fonction des valeurs de distance mesurées par le dispositif de mesure de distance ou en fonction des valeurs de pression mesurées par un dispositif de mesure.
